# EUROPEAN PATENT APPLICATION

(11) **EP 4 057 573 A1**
(43) Date of publication of application: **14.09.2022**
(21) Application number: 20883935.7
(22) Date of filing: 30.10.2020
(51) Int. Cl.: H04L 12/26

(54) **LINK DETECTION METHOD AND APPARATUS, ELECTRONIC DEVICE, AND COMPUTER-READABLE MEDIUM**

(30) Priority: 04.11.2019 CN 201911064955
(71) Applicant: ZTE Corporation, Shenzhen, Guangdong 518057 (CN)
(72) Inventor: XU, Ruina, Shenzhen, Guangdong 518057 (CN)
(74) Representative: Petraz, Gilberto Luigi
(86) International application number: PCT/CN2020/125406
(87) International publication number: WO 2021/088735

(57) **Abstract**

A detection method and apparatus for a link, an electronic device and a computer-readable medium. The method includes: determining a to-be-tested data module according to a received control signal, and connecting test ports of the data module to sampling ports (101); using the sampling ports to acquire test data fed back by the test ports connected to the sampling ports (102); and comparing the test data with pre-stored reference data to determine whether there is a fault in the link in the tested data module (103).

## Description

The present disclosure claims the priority of the Chinese patent application No. CN201911064955.2, filed on November 4, 2019 and entitled "detection method and apparatus for link, electronic device and computer-readable medium", the entirety of which is incorporated herein by reference.

### Field of the Invention

The embodiments of the present disclosure relate to the technical field of electronic technology, in particular to a detection method and apparatus for a link, an electronic device and a computer-readable medium.

### Background of the Invention

With the continuous expansion of channel capacity in mobile communication, the processing capacity of wireless communication system products is getting higher and higher, and the complexity of system-side single boards, the throughput of on-board links, and the integration level of key components on the boards are also getting higher and higher. Great challenges have been encountered in the design of printed circuit boards (PCBs) or single-board welding processes. Due to its short time per bit, high-speed links are more significantly affected by the discontinuity of link impedance. For example, if there are problems such as short circuiting, opening of circuit, rosin joint, and lack of tin filling rate in the high-speed links, data transmission of the high-speed links will be seriously affected.

Current detection methods for the high-speed links are mainly as follows. 1) Signals on pins of chips are directly measured using a high-speed oscilloscope. Although this method can specifically locate which ends are abnormal, this method requires maintenance personnel to have a certain background for handling the high-speed oscilloscope and processing high-speed signals, and maintenance costs of the high-speed oscilloscope and its probes are high. 2) Join test action group (JTAG) ports or functional test (FT) or other methods are adopted for testing. These two test methods can usually locate faulty links, but cannot specifically locate which end of a link occurs abnormal welding which causes the link fault. 3) rosin joint detection of the PCBs with ball grid array (BGA) structures is realized by using an 5D-based X-Ray technology and post-processing. This method requires an expensive and huge X-Ray detection platform, and the cost is high. The above several methods can neither quickly detect the welding quality of the high-speed links nor meet the requirements of sustainability and testability in mass production.

### Summary of the Invention

The embodiments of the present disclosure provide a detection method and apparatus for a link, an electronic device and a computer-readable medium.

In a first aspect, an embodiment of the disclosure provides a detection method for a link, specifically including: according to a received control signal, determining a to-be-tested data module, and connecting test ports of the data module to sampling ports; using the sampling ports to acquire test data fed back by the test ports connected to the sampling ports; and comparing the test data with pre-stored reference data to determine whether there is a fault in the link in the tested data module.

In a second aspect, an embodiment of the disclosure provides a link detection apparatus, including: a control module, configured to, according to a received control signal, determine a to-be-tested data module, and connect a test port of the data module to sampling ports; a sampling module, configured to use the sampling ports to acquire test data fed back by the test ports connected to the sampling ports; and a judgment module, configured to compare the test data with pre-stored reference data to determine whether there is a fault in a link in the tested data module.

In a third aspect, an embodiment of the disclosure provides an electronic device, including: one or more processors; a storage apparatus for storing one or more programs thereon, when the one or more programs are executed by the one or more processors, the one or more processors realize the method described in the first aspect.

In a fourth aspect, an embodiment of the disclosure provides a computer-readable medium for storing a computer program thereon, when the program is executed by a processor, the method described in the first aspect is realized.

### Brief Description of the Drawings

The accompanying drawings are used for providing a further understanding of the embodiments of the present disclosure and constitute a part of the specification to illustrate the disclosure together with embodiments of the disclosure, which do not constitute a limitation on the disclosure. From the detailed description of the exemplary embodiments with reference to the accompanying drawings, the above other features and advantages will become more apparent to those skilled in the art. In the accompanying drawings:
Fig. 1 is a flow diagram of a detection method for a link of a first implementation of the disclosure;
Fig. 2 is a flow diagram of a detection method for a link of a second implementation of the disclosure;
Fig. 3 is a schematic structural diagram of a link detection apparatus of a third implementation of the disclosure;
Fig. 4 is a schematic structural diagram of a link detection apparatus of a fourth implementation of the disclosure; and
Fig. 5 shows a schematic structural diagram of a chip-level communication system including a link detection apparatus of a fifth implementation of the disclosure.

### Detailed Description of the Embodiments

In order to make those skilled in the art to better understand the technical solutions of the present disclosure, a method and apparatus, an electronic device and a computer-readable medium provided by the disclosure will be described in detail below in combination with the accompanying drawings.

Exemplary embodiments will be described more fully hereinafter with reference to the accompanying drawings, but the exemplary embodiments may be embodied in different forms and should not be construed as being limited to the embodiments set forth herein. Rather, the purpose of providing these embodiments is to make the disclosure thorough and complete and enable those skilled in the art to fully understand the scope of the disclosure.

The terms "first" and "second" in the description and claims of the present disclosure and the above accompanying drawings are used for distinguishing similar objects and are not necessarily used for describing a particular order or sequence. It should be understood that data used in such a manner may be interchanged in appropriate circumstances to enable the embodiments described herein to be implemented in sequences other than those illustrated or described herein. Furthermore, the terms "comprising" or "having" and any variants thereof are intended to cover non-exclusive inclusion. For example, a process, method, system, product or device including a series of steps or units is not necessarily limited to including those steps or units that are expressly listed, but may include other steps or units that are not expressly listed or inherent to these processes, methods, products or devices.

All terms (including technical and scientific terms) used herein have the same meaning as those commonly understood by a person of ordinary skill in the art, unless otherwise defined. It will also be understood that terms such as those defined in frequently-used dictionaries should be construed as having meanings consistent with their meanings in the context of the related art and this disclosure, and will not be construed as having idealized or over-formal meanings, unless expressly limited in such a manner herein.

A first implementation of the disclosure relates to a detection method for a link. The method is used for quickly detecting the welding quality of high-speed links to meet the requirements of sustainability and testability in mass production.

The implementation details of the method in this implementation will be specifically described below, and the following content is only for the convenience of understanding the implementation details of this solution, and is not the necessity for implementing this solution.

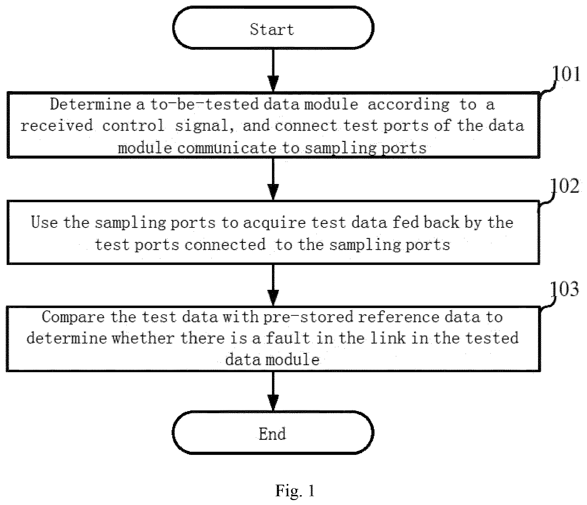

Fig. 1 is a flow diagram of a detection method for a link in this implementation. The method can be applied to a link detection apparatus, which can be located in a SERializer/DESerializer (referred to as SERDES) or an electronic chip containing a SERDES module. The method can include the following steps.

In step 101, according to a received control signal, a to-be-tested data module is determined, and test ports of the data module are connected to sampling ports.

A high-level module sends the control signal to the link detection apparatus, and the link detection apparatus judges, according to the control signal, which data module the sampling port should be specifically connected to. Since there can be a plurality of data modules that need to be detected, the link detection apparatus can, according to different control signals acquired, specifically determine which data module is to be detected, thus connecting the test ports of the corresponding data module to the sampling ports of the link detection apparatus, so as to enable the link detection apparatus to acquire test data output by the data module.

The control signal is a signal generated by the high-level module according to different test requirements. The data module can be a sending module, or a receiving module, or a signal generation module or other modules that can generate test data; and correspondingly, the test data can be sending data generated by the sending module, or test data that is output after being processed by the receiving module, or various test data generated by the signal generation module, etc.. It should be noted that the data module can be set according to the actual situation, and is not limited to the above illustration, and other data modules not illustrated also fall within the protection scope of the disclosure, which is not described in detail herein.

In some specific implementations, the sampling ports include a clock signal end and a data signal end. According to the received control signal, the to-be-tested data module is determined, the clock signal end being connected with a source end of a clock signal of the data module, and the data signal end being connected with a source end of a data signal of the data module.

After determining the to-be-tested data module, it is necessary to connect the clock signal end of the link detection apparatus to the source end of the clock signal of the data module, and connect the data signal end of the link detection apparatus with the source end of the data signal of the data module, so that the link detection apparatus can acquire the clock signal input by the data module from the clock signal end and acquire the data signal input by the data module from the data signal end.

After the link detection apparatus acquire the clock signal and the data signal of the selected data module, the clock signal of the selected data module serves as a reference clock signal of the link detection apparatus to facilitate sampling of the data signal.

In step 102, the sampling ports are used to acquire test data fed back by the test ports connected to the sampling ports.

It should be noted that if it is determined in step 101 that the test ports of a certain data module are connected to the sampling ports, then in this step, the link detection apparatus can acquire the test data output by the data module.

In step 103, the test data is compared with pre-stored reference data to determine whether there is a fault in the link in the tested data module.

In some specific implementations, the fault includes any one of opening of circuit, short circuiting, rosin joint or lack of tin filling rate. If any of the above faults is detected in the link, it means that the welding process of the link does not meet the requirements, and the link needs to be repaired, so that the link faults can be detected as soon as possible in the production process and the defective rate can be reduced.

In some specific implementations, the test data includes the clock signal and a test data waveform. The clock signal is used to sample the test data waveform so as to acquire an amplitude of the test data waveform. According to the amplitude of the test data waveform and a pre-stored preset interval of amplitude, whether there is a fault in the link corresponding to the data module is judged.

The preset interval of amplitude can be a preset interval of amplitude acquired by detecting a plurality of qualified data modules to acquire amplitude data and performing calculation according to the qualified amplitude data. By using the clock signal input by the data module to sample the test data waveform, an amplitude value of a waveform at a fixed time interval can be acquired, so that the amplitude value can represent the changing situation of the test data.

In some specific implementations, if it is determined that a variation value of the amplitude of the test data waveform is within the preset interval of amplitude, it is determined that there is no fault in the link corresponding to the data module; otherwise, it is determined that there is a fault in the link corresponding to the data module.

For example, the preset interval of amplitude ranges from 0.1 to 0.5 of the variation value of amplitude, then when the links corresponding to other data modules are subsequently detected and when it is uncertain whether the link corresponding to the data module meets the standard, the amplitude of the test data waveform output by the data module can be compared with the preset interval of amplitude. For example, if the variation value of amplitude of the test data waveform relative to the amplitude of an original sending waveform is 0.3, it indicates that there is no fault in the link corresponding to the data module because 0.3 is within the allowance range of the preset interval of amplitude [0.1, 0.5]; otherwise, if the variation value of amplitude of the test data waveform relative to the amplitude of the original sending waveform is 0.8, i.e., not within the allowance range of the preset interval of amplitude [0.1, 0.5], it indicates that there is a fault in the link corresponding to the data module, thus needing technical personnel to carry out corresponding handling in time.

The comparison result is obtained by comparing the amplitude of the sampled test data waveform with the preset interval of amplitude, and it can be determined whether there is a fault in the link in the data module according to the comparison result, which makes the detection of the link more specific and parameterized and makes the detection accuracy higher, thereby reducing the detection cost and the detection complexity of high-speed links.

In this implementation, the link detection apparatus gates different to-be-tested data modules according to control signals, obtains the test data fed back by the gated data module, and judges whether there is a fault in the link in the data module according to the test data. Thus, the impedance continuity on the link in the data module can be reflected by the change of the test data, and then the welding quality of the link is quickly detected to determine whether the welding process of each point on the link meets the requirements, so as to meet the requirements of sustainability and testability in mass production and meanwhile reduce the testing cost.

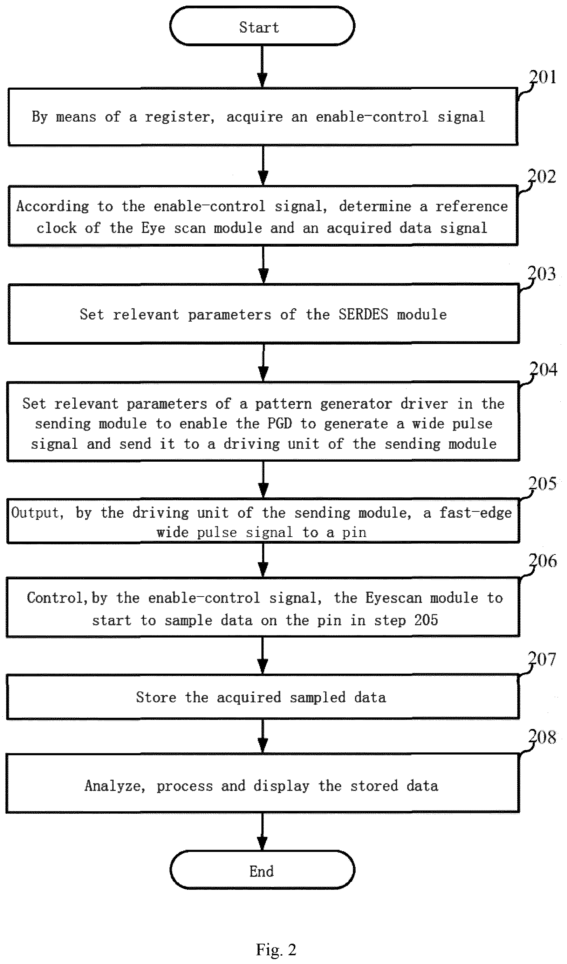

Fig. 2 shows a flow diagram of a detection method for a link of a second implementation of the disclosure. The method can be applied to a link detection apparatus, which can be located in a SERDES module.

In this implementation, a data module includes a sending module and a receiving module, i.e., a sending module and a receiving module in the SERDES module. The link detection apparatus judges, according to a control signal, whether to detect a link in the sending module or a link in the receiving module.

If the received control signal is a sending end detection control signal, the sending module is determined as the to-be-tested data module That is, a clock signal end of the sending module in the SERDES module is electrically connected with an input end of a clock selection module (Clk mux), and a data signal end of the sending module in the SERDES module is electrically connected with an input end of a data selection module (Data mux).

If the received control signal is a receiving end detection control signal, the receiving module is determined as the to-be-tested data module. That is, a clock signal end of the receiving module in the SERDES module is electrically connected with the input end of the clock selection module (Clk mux), and a data signal end of the receiving module in the SERDES module is electrically connected with an input end of a data selection module (Data mux).

In the meantime, an Eye scan module in the SERDES module is used as a sampling module, a signal input end of the sampling module being electrically connected with an output end of the clock selection module (Clk mux), and a data input end of the sampling module being electrically connected with an output end of the data selection module (Data mux). If the received control signal is a receiving end detection control signal, a received clock signal of the Eye scan module is a clock signal of the receiving module, and a received test data is a test data waveform signal output by the receiving module. If the received control signal is a sending end detection control signal, the received clock signal of the Eye scan module is the clock signal of the sending module, and the received test data is a test data waveform signal output by the sending module.

The method can include the following steps.

In step 201, by means of a register, an enable-control signal is acquired.

It should be noted that the enable-control signal can be a sending end control signal or a receiving end control signal, and is a control signal determined by the link detection apparatus according to a control signaling of the high-level module.

In step 202, according to the enable-control signal, a reference clock of the Eye scan module and an acquired data signal are determined.

For example, if the enable-control signal is the sending end control signal, the clock signal at a sending end is output to the Eye scan module to replace the reference clock of the Eye scan module, and meanwhile, a data signal output by the sending end is sent to the Eye scan module. If the enable-control signal is the receiving end control signal, the clock signal at a receiving end is output to the Eye scan module to replace the reference clock of the Eye scan module, and meanwhile, a data signal output by the sending end is sent to the Eye scan module.

In step 303, relevant parameters of the SERDES module are set.

The scanning ranges and step values of horizontal and vertical offsets are taken as examples of the relevant parameters.

In step 204, relevant parameters of a pattern generator driver (PGD) in the sending module are set to enable the PGD to generate a wide pulse signal and send it to a driving unit of the sending module.

It should be noted that a transmission waveform generated by the PGD is superposed with a reflection waveform obtained after the transmission waveform passes through the link corresponding to the sending module, and the test data waveform of the sending module can be obtained; and the transmission waveform is a waveform generated by the sending module according to a wide pulse signal waveform and a fast-edge signal waveform. A fast-edge signal represents a signal whose rising edge/falling edge takes a very short time. For example, the time of a rising/falling edge of the signal output by the driving unit of the sending module of the SERDES module is generally 20 to100 ps. The higher the rate is, the faster the rate of the rising/falling edge goes. The wide pulse signal waveform can be a self-defined wide square wave sequence signal, including several 0 and several 1, where the number of 0 is much smaller than the number of 1. For example, the wide square wave sequence signal includes two 0 and ten 1, represented as "101111111101".

According to a transmission line principle, when sending a transmission waveform, which can serve as a pulse signal, to the link, if there is a point with discontinuous impedance in the link, a reflection waveform can occur. A superposed waveform of the transmission waveform and the reflection waveform is detected at a source end, and data corresponding to the superposed waveform is processed, so that the impedance continuity on the link may be detected.

In step 205, the driving unit of the sending module outputs a fast-edge wide pulse signal to a pin.

It should be noted that the pin can be a pin corresponding to a fast-edge differential positive signal of the sending module, or can be a pin corresponding to a fast-edge differential negative signal.

In step 206, the Eye scan module is controlled by the enable-control signal to start to sample data on the pin in step 205.

In step 207, the acquired sampled data is stored.

In step 208, the stored data is analyzed, processed and displayed.

It should be noted that, in this step, the link can be detected by the above detection method for the link. For example, the data signal can be sampled according to the clock signal to obtain an amplitude value of the data signal, then the amplitude value is compared with a preset interval of amplitude to obtain a comparison result, and whether there is a fault in the link is determined according to the comparison result, that is, whether the impedance of each point on the high-speed link is discontinuous is detected.

In this way, the clock signal and the data signal of the corresponding data module are acquired through the enable-control signal, and then the relevant parameters of the SERDES module and the relevant parameters of the PGD in the sending module are set, so that the PGD can generate a wide pulse signal and send it to the driving unit of the sending module. Therefore, the Eye scan module can acquire the data signal input by the sending module and sample it, and then the impedance continuity of each point on the high-speed link is determined by analyzing the amplitude value of the sampled data signal, so that link detection is parameterized, operation is easy, the requirements of sustainability and testability in mass production are met, and the testing cost is also reduced.

The steps are divided by various methods above only for the purpose of describing clearly, and during implementation, can be combined into one step, or can be split into multiple steps for certain steps, both are within the protection scope of this patent, as long as the logical relationships involved are the same. Whether it is adding insignificant modifications to the algorithm or process or introducing insignificant designs to the algorithm or process, as long as the core design of the algorithm and process is not changed, both are within the protection scope of this patent.

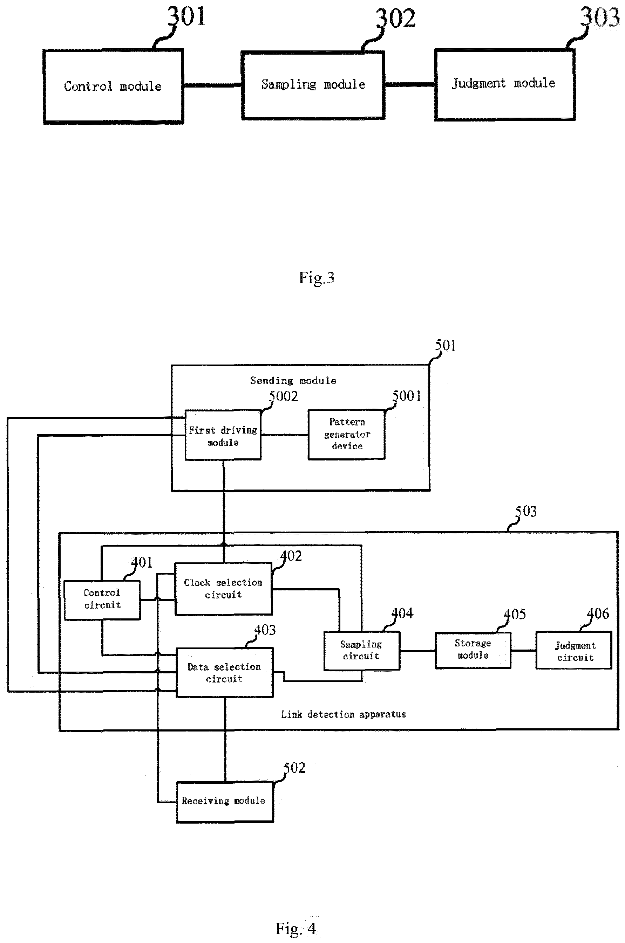

Fig. 3 is a block diagram of a link detection apparatus of a third implementation of the disclosure. For the specific implementation of the apparatus, reference can be made to the relevant description of the first implementation, and it will not be repeatedly described in detail. It is worth noting that for the specific implementation of the apparatus in this implementation, reference can also be made to the relevant description of the second implementation, but it is not limited to the above two embodiments, and other unexplained embodiments are also within the protection scope of the apparatus.

The apparatus mainly includes: a control module 301, configured to, determine a to-be-tested data module according to a received control signal, and connect test ports of the data module to sampling ports; a sampling module 302, configured to use the sampling ports to acquire test data fed back by the test ports connected to the sampling ports; and a judgment module 303, configured to compare the test data with pre-stored reference data to determine whether there is a fault in a link in the tested data module.

In an embodiment, the control module 301 includes: a first control submodule, configured to, if the received control signal is a sending end detection control signal, determine a sending module as the to-be-tested data module; and a second control submodule, configured to, if the received control signal is a receiving end detection control signal, determine a receiving module as the to-be-tested data module.

It should be noted that the present disclosure is not limited to the specific configurations and processes described in the above embodiments and shown in the figures. For the convenience and brevity of description, the detailed description of the known method is omitted here, and for the specific working process of the modules and apparatuses described above, reference can be made to the corresponding process in the foregoing embodiments of methods, which is not described in detail.

Fig. 4 shows a schematic structural diagram of a link detection apparatus of a fourth implementation of the disclosure. The link detection apparatus specifically determines whether to connect to the sending module or the receiving module according to the control signal.

As shown in Fig. 4, the link detection apparatus 503 can include a control circuit 401, a clock selection circuit 402, a data selection circuit 403, a sampling circuit 404, a storage circuit 405 and a judgment circuit 406.

The control circuit 401 can generate two control signals (i.e., a receiving end eye-diagram test signal and a high-speed link detection signal) according to information input by the high level, and output the two control signals to the clock selection circuit 402 and the data selection circuit 403. Different to-be-tested data modules, such as the sending module 501 and the receiving module 502 in FIG. 4, are gated through different control signals.

When the clock selection circuit (Clock mux) 402 receives the receiving end eye-diagram test signal, the receiving module 502 can be selected as the to-be-tested data module, an input end of the clock selection circuit 402 being connected with a source end of a clock signal in the receiving module 502 to acquire the clock signal of the receiving module 502, and the clock signal of the receiving module 502 serving as a reference clock to perform a time level offset. when the clock selection circuit (Clock mux) 402 receives the high-speed link detection signal, the sending module 501 can be selected as the to-be-tested data module, the input end of the clock selection circuit 402 being connected with a source end of a clock signal in the sending module 501 to acquire the clock signal of the sending module 501, and the clock signal in the sending module 501 serving as the reference clock.

It should be noted that the data signal output by the sending module 501 includes a fast-edge differential positive signal and a fast-edge differential negative signal, which are acquired at pins of a package line led out from a chip. If the storage circuit 405 has a cache large enough, more sampled data can be stored, and by detecting and analyzing a large amount of sampled data, the impedance continuity of the receiving pins on the link corresponding to the sending module can be detected.

If the data selection circuit (Data mux) 403 receives the receiving end eye-diagram test signal, the receiving module 502 can be selected as the to-be-tested data module, an input end of the Data mux being connected with a source end of a data signal in the receiving module 502 to acquire the data signal of the receiving module 502. If the data selection circuit (Data mux) 403 receives the high-speed link detection signal, the sending module 501 can be selected as the to-be-tested data module, the input end of the Data mux being connected with a source end of a data signal in the sending module 501 to acquire the data signal of the sending module 501. It should be noted that the data signals output by the sending module 501 can include a differential positive data signal and a differential negative data signal. Therefore, the types of detected signals are increased to improve the accuracy of link detection.

According to the transmission line principle, the data signal, input by the sending module 501 or the receiving module 502, acquired by the data selection circuit 403 is a data waveform obtained after a sending waveform passes through the link corresponding to the sending module 501 or the link corresponding to the receiving module 502 and then is superposed with a reflection waveform generated in the link, and the data waveform reflects the impedance continuity in the link. There may be inductive impedance or capacitive impedance in the link, that is, with the transmission of the sending waveform in the link, the impedance therein may change from large to small, or from small to large, and corresponding to different impedance changes, data waveforms obtained after superposition are also different.

The sampling circuit 404 can be realized by using an Eye scan module in a SERDES module. The Eye scan module samples the input data within a set range of horizontal and vertical offsets to acquire a sampling signal, which includes an amplitude of the data waveform input by the data selection circuit 403. The sampling signal is saved to the storage module 405 for the convenience of acquiring a large number of sampling signals by the judgment circuit 406, so that the judgment circuit 406 can analyze and compare the sampling signals acquired from the storage module 405 to learn whether there is a fault, such as short circuiting, opening of circuit, rosin joint, lack of tin filling rate, etc., in the link corresponding to the sending module 501 or the receiving module 502.

It should be noted that the sending module 501 can include a pattern generator driver 5001, which can generate a wide pulse signal and output it to a first driving circuit 5002, so that the first driving circuit 5002 can quickly synthesize a fast-edge signal and the wide pulse signal to generate a data signal and output it to the data selection module 403.

According to the embodiment of the disclosure, for the specific working process of the link detection apparatus, reference can be made to the processing process corresponding to the detection method for the link described in the foregoing embodiments of methods, which is not described in detail herein.

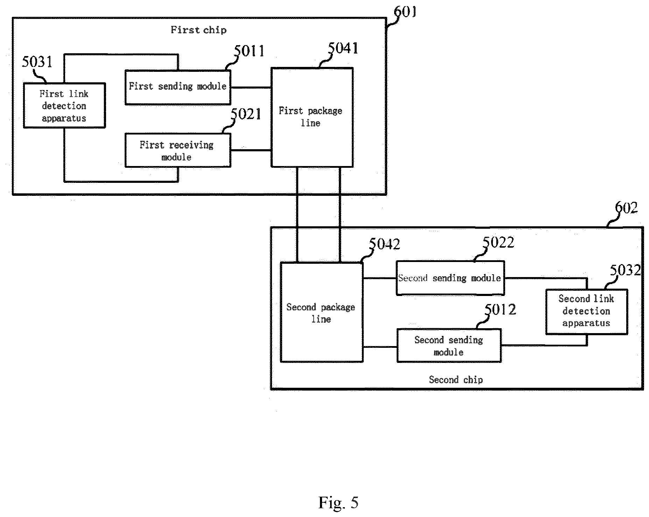

Fig. 5 shows a schematic structural diagram of a chip-level communication system including a link detection apparatus of a fifth exemplary embodiment of the disclosure.

As shown in Fig 5, in an embodiment, an electronic device can include: a first chip 601 and a second chip 602. The first chip 601 includes a first sending module 5011, a first receiving module 5021, a first package line 5041 and a first link detection apparatus 5031. The second chip 602 includes a second sending module 5012, a second receiving module 5022, a second package line 5042 and a second link detection apparatus 5032. The first link detection apparatus 5031 or the second link detection apparatus 5032 can be located in the SERDES module, or can be a link detection apparatus updated based on the SERDES module.

It should be noted that when the first chip 601 communicates with the second chip 602 and if a control signal acquired by the first link detection apparatus 5031 is a high-speed link detection signal, sending waveform data sent by the first sending module 5011 needs to pass through the first package line 5041 and the second package line 5042 to reach the second receiving module 5022 of the second chip 602, so that the first link detection apparatus 5031 can detect the impedance continuity in the above link according to a reflection superposed waveform fed back from the above link. The impedance continuity of the high-speed link consisting of the first sending module 5011, the first package line 5041, the second package line 5042 and the second receiving module 5022 is determined, thus learning whether there are problems of short circuiting, opening of circuit, rosin joint, lack of tin filling rate, etc. in the high-speed link. If the control signal acquired by the first link detection apparatus 5031 is a receiving end eye-diagram test signal, the first link detection apparatus 5031 can detect a link corresponding to the first receiving module 5021 to determine whether there is a fault in the link corresponding to the first receiving module 5021.

Similarly, if the control signal acquired by the second link detection apparatus 5032 is a high-speed link detection signal, sending waveform data sent by the second sending module 5012 needs to pass through the second package line 5042 and the first package line 5041 to reach the first receiving module 5021 of the first chip 601, so that the second link detection apparatus 5032 can detect the impedance continuity in the above link according to the reflection superposed waveform fed back from the above link. The impedance continuity of the high-speed link consisting of the second sending module 5012, the second package line 5042, the first package line 5041 and the first receiving module 5021 is determined, thus learning whether there are problems of short circuiting, opening of circuit, rosin joint, lack of tin filling rate, etc. in the high-speed link. If the control signal acquired by the second link detection apparatus 5032 is a receiving end eye-diagram test signal, the second link detection apparatus 5032 can detect a link corresponding to the second receiving module 5022 to determine whether there is a fault in the link corresponding to the second receiving module 5022.

It should be noted that this detection method can be applied to all high-speed SERDES modules, and the difference lies in that different SERDES modules have different driving capacities and can detect test data with different resolutions. If the first package line 5041 or the second package line 5042 is a copper line where an electric signal has a propagation speed of V = 2.3^{∗}10⁸m/s, the detection accuracy of the first link detection apparatus 5031 or the second link detection apparatus 5032 can be 4.6 mm to 23 mm according to a wide pulse signal carried by a fast-edge signal. If the length of the first package line 5041 or the second package line 5042 is larger than the above detection accuracy, the impedance continuity at BGA welding points in the first chip 601 or the second chip 602 can be detected. For the method of detecting the high-speed link by means of the first link detection apparatus 5031 or the second link detection apparatus 5032, reference can be made to the processing process corresponding to the detection method for the link described in the foregoing embodiments of method, which is not described in detail herein.

It can be known from the above description that the link detection apparatus can detect the impedance continuity of the link between the two chips, and it is worth noting in particular that the detection apparatus can also detect the impedance continuity of the links between the package lines in the chips and has higher accuracy for link detection, so that whether the welding quality of the link meets the requirements can be quickly detected, so as to meet the requirements of sustainability and testability in mass production, and the testing cost is also reduced.

The sixth implementation of the disclosure relates to an electronic device, including: one or more processors; a storage apparatus, storing one or more programs thereon, when the one or more programs are executed by the one or more processors, the one or more processors realizing any one of the above detection methods for the link.

The seventh implementation of the disclosure relates to a computer-readable medium for storing a computer program thereon. When the program is executed by a processor, any one of the above detection methods for the link is realized.

According to an embodiment of the disclosure, the process described above with reference to the flow diagram can be implemented as a computer software program. For example, the embodiment of the disclosure includes a computer program product, including a computer program tangibly contained on the computer-readable medium, the computer program containing a program code used for executing the method shown in a flow diagram. In such an embodiment, the computer program can be downloaded and installed from the network, and/or installed from a removable storage medium.

Compared with the prior art, the embodiment of the disclosure provides a detection method for a link. Different to-be-tested modules are gated according to control signals, test data fed back by the gated data module is acquired, and whether there is a fault in the link in the data module is judged according to the test data, so that the impedance continuity on the link in the data module can be reflected by the change of the test data, and then the welding quality of the link is quickly detected to determine whether the welding process of each point on the link meets the requirements, so as to meet the requirements of sustainability and testability in mass production and meanwhile reduce the testing cost.

A person of ordinary skill in the art may understand that, all or some steps of the methods disclosed above and functional modules/units of a system or an apparatus may be implemented as software, firmware, hardware, and a proper combination thereof. In an implementation of the hardware, a division of the functional modules/units mentioned above does not necessarily correspond to a division of physical components. For example, one physical component may have multiple functions, or one function or step may be implemented by multiple physical components cooperatively. Some physical components or all physical components may be implemented as software executed by a processor, such as a central processor, a digital signal processor or a microprocessor, or may be implemented as hardware, or may be implemented as an integrated circuit, such as an application-specific integrated circuit. Such software may be distributed on a computer-readable medium, and the computer-readable medium may include a computer storage medium (or non-transitory medium) and a communications medium (or transitory medium). As is known to a person of ordinary skill in the art, the term of computer storage medium includes volatile and non-volatile, removable and non-removable mediums that may be implemented in any method or technology for storing information (such as a computer readable instruction, a data structure, and a program module or other data). The computer storage medium includes, but is not limited to, an RAM, an ROM, an EEPROM, a flash memory or other memory technology, a CD-ROM, a digital video disk (DVD) or other optical disk storage, a magnetic cassette, a magnetic tape, a magnetic disk storage or other magnetic storage apparatus, or any other medium which can be used to store the desired information and which can be accessed by a computer. In addition, as is known to a person of ordinary skill in the art, the communications medium usually includes the computer readable instruction, the data structure, and the program module or other data in a modulated data signal, such as a carrier or other transmission mechanisms, and can include any information delivery medium.

It can be understood that the above implementations are merely exemplary implementations adopted to illustrate the principles of the disclosure, but the disclosure is not limited thereto. For a person of ordinary skill in the art, without departing from the spirit and essence of the disclosure, various modifications and improvements can be made, and these modifications and improvements are also regarded as the protection scope of the disclosure.

Exemplary embodiments have been disclosed herein, and although specific terms are adopted, they are used and should be construed only as a general illustrative meaning and not for purpose of limitation. In some instances, it is apparent to those skilled in the art that features, characteristics and/or elements described in combination with a specific embodiment can be used alone, or can be used in combination with features, characteristics and/or elements described in combination with other embodiments, unless otherwise stated expressly. Accordingly, it will be understood by a person of ordinary skill in the art that various changes in form and detail can be made without departing from the scope of the disclosure as set forth in the appended claims.

## Claims

1. A detection method for a link, comprising:
determining a to-be-tested data module according to a received control signal, and connecting test ports of the data module to sampling ports;
using the sampling ports to acquire test data fed back by the test ports connected to the sampling ports;
comparing the test data with pre-stored reference data to determine whether there is a fault in the link in the tested data module.

2. The detection method for the link according to claim 1, wherein the data module comprises a sending module and a receiving module;
the step of determining the to-be-tested data module according to the received control signal comprises:
if the received control signal is a sending end detection control signal, determining the sending module as the to-be-tested data module; and
if the received control signal is a receiving end detection control signal, determining the receiving module as the to-be-tested data module.

3. The detection method for the link according to claim 1, wherein the sampling ports comprise a clock signal end and a data signal end;
the step of determining the to-be-tested data module according to the received control signal, and connecting the test ports of the data module to the sampling ports comprises:
determining the to-be-tested data module according to the received control signal, connecting the clock signal end to a source end of a clock signal of the data module, and connecting the data signal end to a source end of a data signal of the data module.

4. The detection method for the link according to claim 3, wherein the test data comprises the clock signal and a test data waveform;
the step of comparing the test data with pre-stored reference data to determine whether there is a fault in the link in the tested data module comprises:
using the clock signal to sample the test data waveform so as to acquire an amplitude of the test data waveform; and
judging whether there is a fault in the link corresponding to the data module according to the amplitude of the test data waveform and a pre-stored preset interval of amplitude,.

5. The detection method for the link according to claim 4, wherein the step of judging whether there is a fault in the link corresponding to the data module according to the amplitude of the test data waveform and the pre-stored preset interval of amplitude comprises:
if it is determined that a variation value of the amplitude of the test data waveform is within the preset interval of amplitude, determining that there is no fault in the link corresponding to the data module; and
if it is determined that the variation value of the amplitude of the test data waveform is not within the preset interval of amplitude, determining that there is a fault in the link corresponding to the data module.

6. The detection method for the link according to any one of claims 1 to 5, wherein the fault comprises any one of opening of circuit, short circuiting, rosin joint or lack of tin filling rate.

7. A link detection apparatus, comprising:
a control module, configured to, determine a to-be-tested data module according to a received control signal, and connecting test ports of the data module to sampling ports;
a sampling module, configured to use the sampling ports to acquire test data fed back by the test ports connected to the sampling ports; and
a judgment module, configured to compare the test data with pre-stored reference data to determine whether there is a fault in a link in the tested data module.

8. The link detection apparatus according to claim 7, wherein the control module comprises:
a first control submodule, configured to, if the received control signal is a sending end detection control signal, determine a sending module as the to-be-tested data module; and
a second control submodule, configured to, if the received control signal is a receiving end detection control signal, determine a receiving module as the to-be-tested data module.

9. An electronic device, comprising:
one or more processors; and
a storage apparatus for storing one or more programs thereon, when the one or more programs are executed by the one or more processors, the one or more processors realize the detecting method for the link according to any one of claims 1 to 6.

10. A computer-readable medium for storing a computer program thereon, when the program is executed by a processor, the detecting method for the link according to any one of claims 1 to 6 is realized.
